(19) Europäisches Patentamt
European Patent Office
Office européen des brevets

(11) **EP 0 994 362 B1**

(12) **EUROPÄISCHE PATENTSCHRIFT**

(45) Veröffentlichungstag und Bekanntmachung des Hinweises auf die Patenterteilung:
**03.01.2007   Patentblatt 2007/01**

(51) Int Cl.:
***G01R 31/36*** *(2006.01)*

(21) Anmeldenummer: **99116666.1**

(22) Anmeldetag: **26.08.1999**

(54) **Verfahren zur Bestimmung des Ladezustandes und der Hochstrombelastbarkeit von Batterien**

Method for determining the load state and the high current bearing capacity of batteries

Procédé pour déterminer l'état de charge des batteries et leur capacité portante à haut courant

(84) Benannte Vertragsstaaten:
**DE ES FR GB IT**

(30) Priorität: **15.10.1998   DE 19847648**

(43) Veröffentlichungstag der Anmeldung:
**19.04.2000   Patentblatt 2000/16**

(73) Patentinhaber:
- **VB Autobatterie GmbH & Co. KGaA**
  **30419 Hannover (DE)**
- **Volkswagen AG**
  **38436 Wolfsburg (DE)**

(72) Erfinder:
- **Laig-Hörstebrock, Helmut, Dr.**
  **60320 Frankfurt (DE)**
- **Michels, Karsten**
  **38165 Lehre (DE)**
- **Meissner, Eberhard, Dr.**
  **65719 Hofheim (DE)**
- **Dierker, Uwe**
  **38550 Isenbüttel (DE)**
- **Übermeier, Dieter**
  **30173 Hannover (DE)**

(74) Vertreter: **Lins, Edgar et al**
  **Gramm, Lins & Partner GbR,**
  **Theodor-Heuss-Strasse 1**
  **38122 Braunschweig (DE)**

(56) Entgegenhaltungen:
**EP-A- 0 391 106        GB-A- 2 126 735**
**US-A- 5 598 088        US-A- 5 614 804**

- **TAKAYUKI TORIKAI: "RESEARCH AND DEVELOPMENT OF THE MODEL-BASED BATTERY STATE OF CHARGE INDICATOR" PROCEEDINGS OF THE INTERNATIONAL CONFERENCE ON INDUSTRIAL ELECTRONICS, CONTROL, INSTRUMENTATION AND AUTOMATION (IECON),US,NEW YORK, IEEE, Bd. CONF. 18, 9. November 1992 (1992-11-09), Seiten 996-1001, XP000356771 ISBN: 0-7803-0582-5**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die Erfindung betrifft ein Verfahren zur Bestimmung des Ladezustandes und der Hochstrombelastbarkeit von Batterien.

Für den Anwender von Batterien ist es von besonderer Bedeutung, den Ladezustand und die Hochstrombelastbarkeit der Batterien zu kennen. Beispielsweise sind für die Fähigkeit einer Starterbatterie, ein Kraftfahrzeug mit einem Verbrennungsmotor zu starten, der Ladezustand und der Alterungszustand, bzw. der sich abzeichnende Kapazitätsverfall der Batterie maßgeblich, da dadurch die der Starterbatterie entnehmbare Stromstärke bzw. deren Leistungsabgabe begrenzt wird. Von besonderer Bedeutung ist die Ermittlung des Ladezustandes bzw. der Startfähigkeit einer Batterie in den Fällen, in denen beispielsweise intermittierender Motorbetrieb vorliegt, da dann in den Motorstillstandzeiten das Bordnetz des Fahrzeuges mit seinen Verbrauchern weiter betrieben wird, allerdings der Generator keinen Strom erzeugt. Die Überwachung des Ladezustandes und der Startfähigkeit der Batterie muß in solchen Fällen gewährleisten, daß der Energieinhalt der Batterie stets ausreichend bleibt, um den Motor noch zu starten.

Zur Messung des Ladezustandes von Akkumulatoren sind die verschiedensten Verfahren bekannt. In vielen Fällen werden integrierende Meßgeräte benutzt (Ah-Zähler), wobei der Ladestrom gegebenenfalls unter Bewertung mit einem festen Ladefaktor berücksichtigt wird. Da die nutzbare Kapazität einer Batterie stark von der Größe des Entladestroms und der Temperatur abhängig ist, kann auch mit solchen Verfahren keine zufriedenstellende Aussage über die der Batterie noch entnehmbare nutzbare Kapazität getroffen werden.

Aus der DE-PS 2242510 ist es beispielsweise bekannt, bei einem Verfahren zur Messung des Ladezustandes den Ladestrom mit einem von der Temperatur und vom Ladezustand der Batterie selbst abhängigen Faktor zu bewerten.

Der DE-OS 4007883 ist ein Verfahren zu entnehmen, bei dem die Startfähigkeit eines Akkumulators durch Messung von Akkumulatorspannung und Batterietemperatur und Vergleich mit einer für den zu prüfenden Batterietyp geltenden Ladezustandskurvenschar ermittelt wird.

Der DE-OS 19543874 ist ein Berechungsverfahren für die Entladecharakteristik und Restkapazitätsmessung einer Batterie zu entnehmen, bei welchem ebenfalls Strom, Spannung und Temperatur gemessen wird, wobei die Entladungscharakteristik durch eine mathematische Funktion mit gekrümmter Oberfläche angenährt wird.

Die DE-PS 3901680 beschreibt ein Verfahren zur Überwachung der Kaltstartfähigkeit einer Starterbatterie, bei dem die Starterbatterie zeitweise mit einem Widerstand belastet wird und die Spannung, die am Widerstand abfällt gemessen wird. Hierdurch wird geprüft, ob die Kaltstarterfähigkeit der Batterie noch ausreicht. Zur Belastung der Starterbatterie dient dabei der Anlaßvorgang.

Schließlich ist der DE-OS 43 39 568 ein Verfahren zur Ermittlung des Ladezustandes einer Kraftfahrzeug-Starterbatterie zu entnehmen, bei dem Batteriestrom und Ruhespannung gemessen werden und aus diesen auf den Ladezustand geschlossen wird, wobei zusätzlich auch die Batterietemperatur berücksichtigt wird. Dabei werden die während verschiedener Zeiträume gemessen Ladeströme miteinander verglichen und daraus eine Restkapazität ermittelt.

In dem US-Patent 5,598,088 ist ein Verfahren zur Bestimmung des Ladezustandes einer Batterie durch Auswertung des Lade- und Entladestroms beschrieben. Eine Ladungsbilanzierung erfolgt mit Hilfe einer in spezifischen Betriebszuständen gemessenen Batterieruhespannung. Die in der Belastungsphase umgesetzte Strommenge wird ebenfalls als Entladestrom gemessen.

Mit den bekannten Verfahren ist es nicht ohne weiteres möglich, eine in ihrer Genauigkeit ausreichende Angaben des Ladezustandes einer Batterie zu machen, darüber hinaus sind viele dieser bekannten Verfahren aufwendig und daher im Kraftfahrzeug nicht ohne weiteres einsetzbar. Der Erfindung liegt die Aufgabe zugrunde, ein Verfahren zur Ermittlung des Ladezustandes und der Startfähigkeit einer Starterbatterie für Kraftfahrzeuge anzugeben, welches eine ausreichende praktischen Genauigkeit besitzt und auch so einfach ist, dass das Batteriezustands-Erkennungssystem schon nach kurzer Zeit alle notwendig festen Parameter der funktionalen Abhängigkeiten "gelernt" hat und zur Vorhersage fähig wird.

Diese Aufgabe wird bei einem Verfahren der eingangs genannten Art durch die im kennzeichnenden Teil des Anspruchs 1 genannten Merkmale gelöst. In den Unteransprüchen sind vorteilhafte Ausgestaltungen dieses Verfahren angegeben.

Die in Anspruch 1 angegebene Bezeichnung zwischen Ladeszustand SOC (State of Charge) und Ruhespannung $U_{00}$ berücksichtigt die Tatsache, dass die Ruhespannung bei kleinen Ladezuständen zwar nichtlinear mit SOC ansteigt, dann aber in dem für die Praxis relevanten höheren Ladezustandsbereich in einen fast linearen Verlauf übergeht. Verwendet wird deshalb für SOC eine lineare Anpassung an die Ruhespannungs/Ladezustands-Abhängigkeit im Bereich SOC zwischen 0.2 und 1 der Form SOC = $U_{00}/C_1 - C_2$ mit $C_1$ ca. von 1,5 V und $C_2$ ca. 7,5 V (für 6zellige Bleibbatterien).

Nach dem erfindungsgemäßen Verfahren erfolgt in den stromlosen Pausen vor oder nach einer Belastungsphase einer Messung des zeitlichen Verlaufs der jeweiligen Leerlaufspannung $U_o$ des Akkumulators. Daraus wird unter Berücksichtigung batteriespezifischer Parameter eine echte Ruhespannung $U_{oo}$ des Akkumulators berechnet. Während der Belastungsphase wird die umgesetzte Strommenge q gemessen und aus dem Quotienten der Differenz der so berechneten Ruhespannungen und dem Ladungsumsatz wird die so genannte Säurekapazität $Q_o$ des Akkumulators ermittelt, bzw. es wird die Ladezustandsänderung des Akkumulators erfasst. Dazu dient die Beziehung

$$U_{oo2} - U_{oo1} = C_1 \cdot q/Q_o$$

$C_1$ ist eine empirisch aus den Systemeigenschaften des Bleiakkumulators ermittelte Größe. Ihr Wert liegt bei üblichen Starterbatterien bei ca. 1,5 V (6zellige Batterie)

Die Säurekapazität $Q_o$ ist die in elektrischen Äquivalenten ausgedrückte Elektrizitätsmenge, die in der im Akkumulator vorhandenen Schwefelsäure gespeichert ist.

Die während der Belastungsphase umgesetzte Strommenge q wird durch integrierende Messung des Batteriestromes i ermittelt. Die Spannungsmessung in den Ruhepausen der Batterie erfolgt vorzugsweise in vorgegebenen zeitlichen Abständen. Die zeitlichen Abstände werden dabei so gewählt, dass eine ständige Überwachung der Batterie erfolgt, beispielsweise kann die Messung in minütlichen Abständen erfolgen.

Es ist zweckmäßig, alle gemessenen Daten auf eine vorgegebene Temperatur von beispielsweise 25 ° C zu normieren. Bei der Berechnung der echten Ruhespannung $U_{oo}$ aus den gemessenen Leerlaufspannungen wird die Spannungslage, der zeitliche Verlauf der Akkumulatorspannung und die Dauer der vorhergehenden Ruhepause berücksichtigt. Die echte Ruhespannung wird aus zwei nacheinander in einer Pause gemessenen Ruhespannungen ermittelt. Um bei dieser Berechnung befriedigende Ergebnisse zu erhalten, sollte der erste verwendete Spannungswert nach einem Mindestzeitraum von ca. 2 Stunden gemessen werden und der zweite verwendete Spannungswert nach weiteren ca. 2 Stunden Pause gemessen werden.

Um weitere Angaben über den Zustand der Batterie machen zu können, insbesondere um gegebenenfalls Voraussagen über die zukünftige Startfähigkeit zu machen, wird der Innenwiderstand $R_i$ der Batterie durch eine Hochstrombelastung, beispielsweise beim Startvorgang bestimmt. Aus dem ermittelten Innenwiderstand und den vorher errechneten Batteriedaten läßt sich eine Prognose für die zukünftige Startfähigkeit der Batterie ableiten.

Während der Batterieruhepause erfolgt eine Messung der Leerlaufspannung $U_0$ der Batterie. Für die Auswertung dieser Leerlaufspannung wird zweckmäßigerweise eine Mindestruhezeit eingehalten, die im Bereich von ca. 4 Stunden liegt. Als Pausenzeit wird dabei ein Zeitraum verstanden, in dem der Strom geringer ist als ca. 0,1A bei einer Batterie 12V/50 Ah. Sobald größere Ströme fließen beginnt die Pausenzeit erneut ab Ende dieser Belastungen.

In den Fällen, in denen $U_0$ nach mehr als einer Stunde noch größer ist als 13,2 V (6-zellige Batterie), muß keine weitere Messung erfolgen, da davon ausgegangen werden kann, daß ein Volladezustand vorliegt. Wenn die Ruhepause zwischen 4 und 8 Stunden liegt und die Ruhespannung dabei abfällt, ergibt sich die echte Ruhespannung $U_{00}$ aus folgender Beziehung

$$U_{00} = U_0(4h) - \alpha\, (U_0(2h) - U_0(4h))$$

wobei

$\alpha$ = 2,5 - 3,5 für T = 25°C
$\alpha$ = 15 - 20 für T = -18°C

In allgemeiner Form läßt sich $U_{00}$ aus $U_0$ gemäß folgender Beziehung ermitteln:

$$U_{00} = U_0(t) + ((\alpha + 2) - \ln(t)/\ln(2))\, (U_0(t) - U_0(t/2))$$

(mit Zeit t in Stunden)

Will man die Genauigkeit noch steigern, so kann man für $\alpha$ auch noch eine $U_0(t)$-Abhängigkeit einführen.

Wenn während der Ruhepause die Ruhespannung $U_0$ ansteigt, ist die Ruhespannungseinstellung nach ca. 4h im allgemeinen abgeschlossen, d.h.:

$$U_{00} = U_0(t{>}4h)$$

Da die Bestimmung der echten Ruhespannung $U_{00}$ aus einer Entladung der Batterie heraus im allgemeinen wesentlich genauer ist, als die Messung ausgehend von einer vorhergegangenen Ladung, kann der errechnete Wert der echten Ruhespannung mit einem Gewichtungsfaktor bewertet werden, der für Entladung höher ist als für Ladung.

Vorteilhaft ist es, die gemessenen Spannungswerte stets auf eine bestimmte Temperatur, beispielsweise auf 25°C zu normieren. Diese Normierung erfolgt nach der Formel

$$U_{00}\,(25°C) = U_{00}(T) - (T - 25°C) \cdot \beta$$

Der Faktor $\beta = \approx 0{,}0014$ V/Grad gilt für eine 6-zellige Bleistarterbatterie. Er ist mit steigender Zellenzahl proportional zu erhöhen bzw. zu erniedrigen.

Die aus der jeweils letzten Messung berechnete Leerlaufspannung $U_{00}$ ist ein Maß für den relativen Ladezustand SOC (State of Charge) der Batterie, wobei:

$$SOC = U_{00}\,(25°C) / C_1 - C_2$$

Aus zwei so bestimmten Ruhespannungen und der im zwischenliegenden Zeitraum dem Akkumulator entnommenen bzw. in den Akkumulator eingeladenen Elektrizitätsmenge $q = \int i\,dt$ läßt sich die Säurekapazität $Q_0$ des Akkumulators abschätzen. Diese Säurekapazität, die sich gemäß

$$Q_0 = C_1 \cdot q/(U_{002} - U_{001})$$

aus den gemessenen Werten ergibt, ist das Kapazitätsäquivalent der bei Nichtbegrenzung durch die Batterie-Elektrode bei der Entladung theoretisch im Bleiakku umsetzbaren Schwefelsäuremenge. Der Wert von $C_1$ liegt bei ca. 1,5 V und der Wert von $C_2$ bei ca. 7,5 bei einer 6zelligen Batterie.

Der absolute Ladezustand der Batterie in Amperesekunden zu diesem Zeitpunkt ergibt sich aus $SOC \cdot Q_0$.

Um aus den bisher ermittelten Werten zusätzlich noch Prognosen über die Startfähigkeit der Batterie zu einem späteren Zeitpunkt machen zu können, muß ergänzend noch der Innenwiderstand $R_i$ der Batterie gemessen werden.

Der Innenwiderstand der Batterie ergibt sich durch eine Spannungs- und Strommessung bei hoher Belastung. Dazu dient insbesondere eine Spannungs- und Strommessung bei einem Startvorgang.

Beispielsweise ergibt sich $R_i$ aus

$$R_i = (U_{Last} - U_0) / (I_{Last} - I_0)$$

wobei $U_0$ die zuletzt gemessene Ruhespannung und $I_0$ der zuletzt gemessene Grundstrom, verursacht durch andere Verbraucher, wie Fahrzeugbeleuchtung etc., sind.

Der Verlauf des Innenwiderstandes einer Starterbatterie in Abhängigkeit vom Ladezustand ist für Ladezustände von mehr als 50% praktisch konstant, steigt aber bei geringen Ladezuständen stark an. Um diesen Verlauf bei der Feststellung der Startfähigkeit des Akkumulators zu berücksichtigen, wird der Innenwiderstand $R_i$ aus zwei Teilen zusammengesetzt: einem vom Ladezustand fast unabhängigen nur temperaturabhängigen Teil $R_1$ und einem für SOC < 0,5 stark mit SOC veränderlichen Anteil $R_2$.

$$R_i = R_1\,(T) + R_2\,(SOC)$$

Wenn der Ladezustand größer ist als 50%, erfolgt die Bestimmung von $R_1$ aus:

$$R_1 = R_i$$

Wenn der Ladezustand kleiner ist als 50%, erfolgt die Bestimmung von $R_2$

$$R_2 = R_i - R_1$$

Für $R_2$ hat sich eine Form $R_2 = \exp(-b(SOC - SOC_{gr}))$ bewährt mit $b \approx 21$. $SOC_{gr}$ wird daraus ermittelt.

Wenn beispielsweise die Ermittlung des Ladezustandes mit einer neuen Batterie begonnen werden soll, so muß zuerst eine Annahme über die Kapazität der Starterbatterie, beispielsweise 60 Ah, und über den Grenz-$SOC_{gr}$ z.B. 0,2 und über den Innenwiderstand (beispielsweise 14 mΩ) gemacht werden. Aus der Anfangsruhespannung $U_{00}$ wird der Ladezustand wie oben erläutert berechnet.

Aus dem ersten Startvorgang wird der Innenwiderstand $R_i$ und der Ladezustand SOC ermittelt. Diese Werte werden, wenn sie zu einem späteren Zeitpunkt neu bestimmt werden, nicht voll übernommen, sondern der letzte Wert wird je nach Qualität der neuen Messung korrigiert. Je größer die zwischen den Pausen eingeladene oder entnommene Kapazitätsmenge ist, desto genauer kann die Säurekapazität ermittelt werden und um so eher kann der neue Wert voll übernommen werden. Zweckmäßig ist es den neu ermittelten Innenwiderstand fest, z.B. mit 10% der Abweichung, zu übernehmen. Wenn die Auswertung der echten Ruhespannung einen höheren Wert für den Ladezustand ergibt, als die Berechnung aus der Summe der alten Ladezustandsbestimmung und der gemessenen Ladezustandsänderung, wird zur Sicherheit und aus Plausibilitätsgründen nicht der volle aus $U_{00}$ berechnete SOC-Wert übernommen, sondern ein korrigierter Wert.

Aus den erfindungsgemäßen Zusammenhängen läßt sich eine Prognose über die Wiederstartfähigkeit einer Batterie, beispielsweise nach längerer Ruhepause, abgeben. Dies ist beispielsweise sinnvoll, wenn ein Fahrzeug im Winter abends abgestellt wird und bei entsprechend tiefer Außentemperatur ermittelt werden soll, ob die Batterie noch in der Lage ist, daß Fahrzeug am nächsten Morgen bei gegebenenfalls anderen Temperaturen sicher zu starten.

Zur Lösung dieser Prognoseaufgabe wird aus den im System gespeicherten Minimumaußentemperaturen der letzten drei Tage ein $T_M$ aus

$$T_M = \text{Min}(T_{min}) - 10°C$$

gebildet. Die zusätzliche Erniedrigung um weitere 10°C ist ein Sicherheitsfaktor und kann je nach den klimatischen Verhältnissen des Standortes angepaßt werden.

Aus dem bekannten letzten Ladezustand ($SOC_j$) und der zuletzt bestimmten Ladezustandsänderung $q / Q_0$ wird ein Ladezustand SOC gebildet durch

$$SOC = SOC_j + q/Q_0$$

Aus SOC wird wie oben erwähnt $U_{00}$ für die angenommene Temperatur ermittelt.

Damit ist die zu erwartende Ruhespannung für den prognostizierten Startvorgang bekannt. Aus der bereits erläuterten Abhängigkeit von Innenwiderstand $R_i$ und Ladezustand SOC wird der zum Startzeitpunkt zu erwartende Innenwiderstand berechnet.

Unter Annahme des notwendigen Startstromes $I_{start}$ für einen kalten Motor ergibt sich damit eine prognostizierte Startspannung $U_{start} = U_{00} - R_i \times I_{start}$. Aus dieser Beziehung heraus kann festgestellt werden, ob die Startspannung, die zu erwarten ist, noch größer ist als eine vorgegebene Spannung. Wenn die Startspannung größer ist als diese vorgegebene Spannung kann am nächsten Morgen der Motor noch sicher gestartet werden, ist die Spannung allerdings kleiner, so ist keine ausreichende Sicherheit mehr gegeben und die Batterie muß geladen werden. Mit dieser Berechnungsmethode ist es nicht nur möglich eine Wiederstartfähigkeit der Batterie zu prognostizieren, sondern auch während des laufenden Betriebs kann, beispielsweise bei Fahrzeugen mit intermittierenden Motorbetrieb, der Zeitpunkt des Wiederstartens des Motors festgelegt werden.

Die für das beschriebene Verfahren notwendigen Ausgangsmeßwerte ($U_0$, T, I) lassen sich im Kraftfahrzeug leicht ermitteln. Diese Daten können in an sich bekannten elektronischen Meßwertverarbeitungssystemen ausgewertet werden und entsprechende Anzeigen im Kraftfahrzeug ansteuern.

**Patentansprüche**

1. Verfahren zur Bestimmung des Ladezustandes und der Hochstrombelastbarkeit von Batterien, wobei in den stromlosen Pausen vor und nach einer Belastungsphase der Batterie der zeitliche Verlauf der Leerlaufspannung $U_{01}$ und der zeitliche Verlauf der Leerlaufspannung $U_{02}$ der Batterie gemessen werden und während der Belastungsphase die umgesetzte Strommenge q gemessen wird, **dadurch gekennzeichnet, dass** eine Ruhespannung $U_{001}$ für die stromlose Pause vor der Belastungsphase aus dem Leerlaufspannungsverlauf $U_{01}$ und eine Ruhespannung $U_{002}$ für die stromlose Pause nach der Belastungsphase aus dem Leerlaufspannungsverlauf $U_{02}$ unter Berücksichtigung batteriespezifischer Parameter berechnet wird, dass aus einer Beziehung der Form $U_{002}-U_{001}=C_1 q/Q_0$ die Säurekapazität $Q_0$ der Batterie ermittelt wird und dass für den relativen Ladezustand SOC der Batterie eine lineare Anpassung an die Ruhespannungs-/Ladezustands-Abhängigkeit der Form $SOC=U_{002}/C_1-C_2$ verwendet wird, woraus sich der absolute Ladezustand der Batterie als $SOC \cdot Q_0$ berechnet, wobei $C_1$ eine empirisch aus den Systemeigenschaft der Batterie ermittelte Größe und $C_2$ eine zur linearen Anpassung des relativen Ladezustands $SOC_i$ an die Ruhespannungs-/Ladezustands-Abhängigkeit gewählte Größe ist.

2. Verfahren nach Anspruch 1, **dadurch gekennzeichnet, dass** bei der Berechnung der Ruhespannungen $U_{001}$ und $U_{002}$ aus der gemessenen Leerlaufspannung $U_{01}$ bzw. $U_{02}$ die Spannungslage, der zeitliche Spannungsverlauf und die Dauer der Ruhepause berücksichtigt wird.

3. Verfahren nach Anspruch 1 oder 2, **dadurch gekennzeichnet, dass** die Messung der Leerlaufspannung $U_{01}$ und $U_{02}$ während der Ruhepausen in festen vorgegebenen Abständen erfolgt.

4. Verfahren nach einem der Ansprüche 1 bis 3, **dadurch gekennzeichnet, dass** die berechneten Ruhespannungswerte $U_{001}$ und $U_{002}$ durch Korrekturfaktoren auf eine vorgegebene Temperatur normiert werden.

5. Verfahren nach einem oder mehreren der Ansprüche 1 bis 4, **dadurch gekennzeichnet, dass** die Berechnung der Ruhespannungen $U_{001}$ und $U_{002}$ aus Messungen der Leerlaufspannungen $U_{01}$ bzw. $U_{02}$ nach einer Mindestruhezeit von ca. 2 Std. erfolgt.

6. Verfahren nach einem oder mehreren der Ansprüche 1 bis 5, **dadurch gekennzeichnet, dass** durch Hochstrombelastung der Batterie der Innenwiderstand $R_i$ als Quotient aus den Differenzen der Spannungen und der Ströme vor und während der Hochstrombelastung ermittelt wird.

7. Verfahren nach einem der Ansprüche 1 bis 6, **dadurch gekennzeichnet, dass** aus dem Innenwiderstand $R_i$, einer vorgegebenen Temperatur und dem zuletzt ermittelten Ladezustand eine Ruhespannung für einen späteren Zeitpunkt prognostiziert wird, aus der mit dem bekannten zum Start eines Verbrennungsmotors notwendigen Strom eine Aussage über die Fähigkeit der Batterie zum Starten des Verbrennungsmotors abgeleitet wird.

**Claims**

1. Method for determining the state of charge and the heavy-current load capacity of batteries, the profile over time of the no-load voltage $U_{01}$ and the profile over time of the no-load voltage $U_{02}$ of the battery being measured in the zero-current pauses before and after a loading phase of the battery, and the amount of current q converted being measured during the loading phase, **characterized in that** an open-circuit voltage $U_{001}$ for the zero-current pause before the loading phase is calculated from the no-load voltage profile $U_{01}$, and an open-circuit voltage $U_{002}$ for the zero-current pause after the loading phase is calculated from the no-load voltage profile $U_{02}$ taking into consideration battery-specific parameters, **in that** the acid capacity $Q_0$ of the battery is determined from a relationship of the form $U_{002}-U_{001}=C_1 q/Q_0$, and **in that** linear matching to the open-circuit voltage/state of charge dependency of the form $SOC=U_{002}/C_1-C_2$ is used for the relative state of charge SOC of the battery, from which the absolute state of charge of the battery is calculated as $SOC \cdot Q_0$, where $C_1$ is a variable which is determined empirically from the system property of the battery, and $C_2$ is a variable which is selected for the linear matching of the relative state of charge $SOC_i$ to the open-circuit voltage/state of charge dependency.

2. Method according to Claim 1, **characterized in that** the voltage, the voltage profile over time and the duration of the rest pause are taken into consideration in the calculation of the open-circuit voltages $U_{001}$ and $U_{002}$ from the measured no-load voltage $U_{01}$ and $U_{02}$, respectively.

3. Method according to Claim 1 or 2, **characterized in that** the measurement of the no-load voltage $U_{01}$ and $U_{02}$ takes place during the rest pauses at fixed, predetermined intervals.

4. Method according to one of Claims 1 to 3, **characterized in that** the calculated open-circuit voltage values $U_{001}$ and $U_{002}$ are standardized by correction factors to a predetermined temperature.

5. Method according to one or more of Claims 1 to 4, **characterized in that** the calculation of the open-circuit voltages $U_{001}$ and $U_{002}$ from measurements of the no-load voltages $U_{01}$ and $U_{02}$, respectively, takes place after a minimum rest time of approximately two hours.

6. Method according to one or more of Claims 1 to 5, **characterized in that**, owing to the heavy-current loading of the battery, the internal resistance $R_i$ is determined as a quotient from the differences in the voltages and the currents before and during the heavy-current loading.

7. Method according to one of Claims 1 to 6, **characterized in that** an open-circuit voltage for a later point in time is predicted from the internal resistance $R_i$, a predetermined temperature and the state of charge which was most recently determined, from which open-circuit voltage, with the known current required for starting an internal combustion engine, information is derived on the capability of the battery to start the internal combustion engine.


**Revendications**

1. Procédé de détermination de l'état de charge de batteries et de leur capacité de sollicitation par un courant élevé, selon lequel pendant les pauses sans courant on mesure respectivement le tracé dans le temps avant et après une phase de sollicitation de la batterie, de la tension à vide Uoi et de la tension à vide $U_{02}$ de la batterie et, pendant la phase de sollicitation, on mesure la quantité de courant transformée q,
   **caractérisé en ce qu'**
   on calcule une tension au repos $U_{001}$ pour la pause sans courant avant la phase de sollicitation à partir du tracé de la tension à vide Uoi, et une tension au repos $U_{002}$ pour la pause sans courant après la phase de sollicitation à partir du tracé de la tension à vide $U_{02}$, en prenant en compte des paramètres spécifiques à la batterie, on détermine la réserve d'acide $Q_0$ de la batterie à partir d'une relation de la forme $U_{002}-U_{001}=C_1\,q/Qo$, et pour l'état de charge relatif SOC de la batterie, on utilise une adaptation linéaire à la relation tension au repos/état de charge de la forme $SOC=U_{002}/C_1-C_2$, en calculant l'état de charge absolu de la batterie selon SOC-Qo, ou $C_1$ est une grandeur déterminée de manière empirique à partir des propriétés système de la batterie et $C_2$ est une grandeur choisie pour l'adaptation linéaire de l'état de charge relatif $SOC_i$ à la relation tension au repos/état de charge.

2. Procédé selon la revendication 1,
   **caractérisé en ce que**
   lors du calcul des tensions au repos $U_{001}$ et $U_{002}$ à partir de la tension à vide Uoi ou $U_{02}$, on prend en compte la situation de la tension, le tracé de la tension dans le temps et la durée de la pause de repos.

3. Procédé selon la revendication 1 ou 2,
   **caractérisé en ce que**
   la mesure de la tension à vide Uoi et $U_{02}$ s'effectue pendant les pauses de repos à intervalles fixes prédéterminés.

4. Procédé selon l'une quelconque des revendications 1 à 3,
   **caractérisé en ce que**
   les valeurs de tension au repos calculées $U_{001}$ et $U_{002}$ sont normalisées à une température prédéterminée par des facteurs de correction.

5. Procédé selon l'une quelconque ou plusieurs des revendications 1 à 4,
   **caractérisé en ce que**
   le calcul des tensions au repos $U_{001}$ et $U_{002}$ s'effectue à partir de mesures des tensions à vide $U_{01}$ ou $U_{02}$ après un temps de repos minimum d'environ 2 heures.

6. Procédé selon l'une quelconque ou plusieurs des revendications 1 à 5,
**caractérisé en ce que**
par une sollicitation de la batterie par un courant élevé, la résistance interne Ri est déterminée comme le quotient des différences de tensions et de courants, avant et pendant la sollicitation par un courant élevé.

7. Procédé selon l'une quelconque ou plusieurs des revendications 1 à 6,
**caractérisé en ce qu'**
à partir de la résistance interne Ri, d'une température prédéterminée et de l'état de charge déterminé en dernier, on pronostique une tension au repos pour un moment ultérieur, à partir de laquelle, avec le courant nécessaire connu pour démarrer un moteur à combustion interne, on déduit une information sur la capacité de la batterie à démarrer le moteur à combustion interne.